# EUROPEAN PATENT APPLICATION

(11) **EP 4 586 362 A2**
(43) Date of publication of application: **16.07.2025**
(21) Application number: 24218113.9
(22) Date of filing: 06.12.2024
(51) Int. Cl.: H01M 10/42, H01M 10/48, H01M 50/204, H01M 50/284, H01M 50/519, H01M 50/569, H05K 1/00

(54) **RECHARGEABLE BATTERY MODULE**

(30) Priority: 05.01.2024 KR 20240002487
(71) Applicant: SAMSUNG SDI CO., LTD., Yongin-si, Gyeonggi-do 17084 (KR)
(72) Inventor: Ahn, Jaepil, 17084 Yongin-si, Gyeonggi-do (KR)
(74) Representative: Gulde & Partner

(57) **Abstract**

A rechargeable battery module includes a bus bar holder covering battery cells; a bus bar on the bus bar holder to electrically connect the battery cells; and a flexible printed circuit on the bus bar holder to transmit a signal that detects a voltage of the battery cell connected to the bus bar. The bus bar includes an extension portion protruding in one direction, and the flexible printed circuit includes a main body portion, a branch portion extending from the main body portion, and an expansion portion having an expanded area on the branch portion that is soldered to the extension portion.

## Description

### BACKGROUND

### 1. Field

The present disclosure relates to a rechargeable battery module.

### 2. Description of the Related Art

Unlike a primary battery, a rechargeable battery is a battery that repeatedly performs charging and discharging. Small-capacity rechargeable batteries are used in portable small electronic devices such as mobile phones, laptop computers, and camcorders.

High-capacity and high-density rechargeable batteries are used as power sources for driving motors in hybrid and electric vehicles or as energy storages. The rechargeable battery may be used by forming a rechargeable battery module including a plurality of battery cells connected in series and/or in parallel so as to drive a motor of, for example, a hybrid vehicle requiring a relatively high energy density.

The rechargeable battery module detects the voltage of the cell through a bus bar connected to the cell and transmits the detected signal through a flexible printed circuit (FPC). A nickel tab (Ni-Tab) is used to connect the FPC to the bus bar. Nickel tabs increase process and material costs.

The above-described information disclosed in the technology that serves as the background of the present disclosure is only for improving understanding of the background of the present disclosure and thus may include information that does not constitute the related art.

### SUMMARY

An embodiment of the present disclosure includes a rechargeable battery module that improves connection quality by directly connecting a flexible printed circuit (FPC) and a bus bar. An embodiment of the present disclosure includes a rechargeable battery module that may achieve a desired resistance value and peel strength by bonding a soldering pattern of a flexible printed circuit (FPC) to a bus bar with a laser.

In one embodiment, the rechargeable battery module includes a bus bar holder covering battery cells; a bus bar on the bus bar holder that electrically connects the battery cells; and a flexible printed circuit on the bus bar holder. The flexible printed circuit includes a film coating both surfaces of a circuit pattern. The flexible printed circuit is configured to transmit a signal that detects a voltage of a battery cell connected to the bus bar. The bus bar includes an extension portion protruding in one direction, and the flexible printed circuit comprises a main body portion, a branch portion extending from the main body portion, and an expansion portion soldered to the extension portion. The expansion portion has a larger area than the branch portion.

The expansion portion may include at least one through hole penetrating a foil connected to the circuit pattern, at least one soldering pattern exposed by an opening in a film around the at least one through hole, and a soldering portion bonding the extension portion exposed through the at least one through hole to the at least one soldering pattern.

The foil may include copper or aluminum.

The expansion portion may have an area including a first length in a length direction of the branch portion and a first width in a width direction crossing the length direction.

The branch portion may be at an outermost side of the expansion portion in the width direction, the branch portion may have a width that is smaller than the first width of the expansion portion, and the branch portion may extend in the length direction.

The rechargeable battery module may include a rounded corner where the branch portion and the expansion portion are connected.

The at least one through hole may include two or more through holes arranged in a width direction and a length direction.

The at least one through hole may include two or more through holes, two through holes may be arranged in the width direction, and another two through holes of the plurality of through holes may be arranged in the length direction.

Each of the through holes may have a slot hole structure having a hole width in the width direction and a hole length in the length direction.

The at least one soldering pattern may include two or more soldering patterns, and each of the soldering patterns may include a pattern width on both sides of each of the through holes in the width direction and having substantially a same size as the hole width, and a pattern length connected to both sides of the pattern width in the length direction that has a larger curvature than the slot hole structure of each of the through holes.

The expansion portion may include an eleventh inner-coating portion between two soldering patterns in the width direction that includes a portion of the foil coated with the film, and a twelfth outer coating portion outside the two soldering patterns in the width direction that includes another portion of the foil coated with the film. The eleventh inner-coating portion may have a size substantially equal to approximately twice that of the twelfth outer coating portion.

The expansion portion may include a first concave portion in the twelfth outer coating portion.

The expansion portion may include a 21st inner-coating portion between two soldering patterns in the length direction that includes a portion of the foil coated with the film, and a 22nd outer coating portion outside the two soldering patterns in the length direction that includes another portion of the foil coated with the film. The 21st inner-coating portion may have a size smaller than that of the 22nd outer coating portion.

The expansion portion may include a second concave portion in the 22nd outer coating portion.

The soldering portion may bond the soldering pattern and the extension portion exposed through the at least one through hole.

According to one or more embodiments of the present disclosure, connection quality may be achieved while directly connecting the flexible printed circuit (FPC) and the bus bar by soldering and bonding the expansion portion in the branch portion of the flexible printed circuit to the extension portion of the bus bar.

In addition, according to one or more embodiments of the present disclosure, it is possible to secure the resistance value and peel strength at the connection between the bus bar and the flexible printed circuit by irradiating a laser to the through hole of the expansion portion of the flexible printed circuit (FPC), melting the solder, and soldering and bonding the soldering pattern and the extension portion exposed by the through hole.

### BRIEF DESCRIPTION OF THE DRAWINGS

FIG. 1 illustrates a partial top plan view of a rechargeable battery module according to an embodiment of the present disclosure.
FIG. 2 illustrates a top plan view in which a connection portion of a flexible printed circuit is connected to a bus bar applied to FIG. 1.
FIG. 3 illustrates an enlarged top plan view of the connection portion of the flexible printed circuit for the bus bar in FIG. 2.
FIG. 4 illustrates a planar image of the connection portion of the flexible printed circuit applied to FIG. 1 to FIG. 3.
FIG. 5 illustrates an image in which a connection portion of a flexible printed circuit is bonded to a bus bar applied to FIG. 1.
FIG. 6 illustrates images of a first experimental example and a second experimental example in which a connection portion of a flexible printed circuit is connected to a bus bar according to an embodiment of the present disclosure.
FIG. 7 illustrates images of a third experimental example and a fourth experimental example in which a connection portion of a flexible printed circuit is connected to a bus bar according to an embodiment of the present disclosure.
FIG. 8 illustrates images of a fifth experimental example and a sixth experimental example in which a connection portion of a flexible printed circuit is connected to a bus bar according to an embodiment of the present disclosure.
FIG. 9 illustrates images of a seventh experimental example and an eighth experimental example in which a connection portion of a flexible printed circuit is connected to a bus bar according to an embodiment of the present disclosure.
FIG. 10 illustrates images of a ninth experimental example and a tenth experimental example in which a connection portion of a flexible printed circuit is connected to a bus bar according to an embodiment of the present disclosure.

### DETAILED DESCRIPTION

The present disclosure will be described more fully hereinafter with reference to the accompanying drawings, in which an embodiment of the disclosure is shown. As those skilled in the art would realize, the described embodiments may be modified in various different ways, all without departing from the scope of the present disclosure. The drawings and description are to be regarded as illustrative in nature and not restrictive, and like reference numerals designate like elements throughout the specification.

Recently, due to the demand for increased energy of rechargeable battery modules, the size of the modules has increased. As a result, the size of flexible printed circuits (FPC) increases, which may increase material costs and may weaken price competitiveness.

In order to achieve price competitiveness of rechargeable battery modules, low-cost flexible printed circuits that may reduce the material cost of expensive flexible printed circuits (FPC) are desired. Therefore, it is desired to simplify the structure of the portion connecting the flexible printing circuit and the bus bar.

As the size of the module increases, the length of the flexible printed circuit for sensing the voltage and temperature of the cell should be manufactured to be equal to or greater than a set value (1m). The manufacturing process equipment for flexible printed circuits is at the level of 500 mm, so building separate equipment is necessary to manufacture them in sizes of 1 M or more.

Therefore, the processing cost of the flexible printed circuit increases, and the price of the flexible printed circuit may significantly increase due to the use of expensive copper as a material. In this case, the competitiveness of rechargeable battery modules may be weakened.

In addition, an aluminum foil is a low-cost material that may replace expensive a copper foil in the flexible printed circuit, but in order to apply the aluminum foil, it is necessary to secure element technology related to the bonding of sub-components such as a temperature sensing element (NTC) and a nickel tab (Ni-tab).

In addition, in order to eliminate the nickel tab (Ni-tab), which is a connection component for voltage sensing of cells through the bus bar, element technology is needed for direct bonding of the bus bar and the flexible printed circuit.

In the embodiment of the rechargeable battery module, because the flexible printed circuit uses an aluminum foil, material costs may be lowered, and because the flexible printed circuit may be directly connected to the bus bar without using a nickel tab, material costs may be reduced. Hereinafter, a rechargeable battery module of such an embodiment will be described.

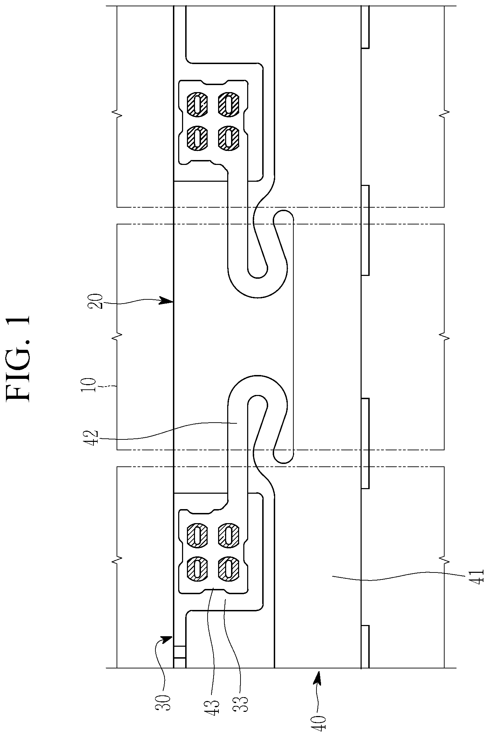

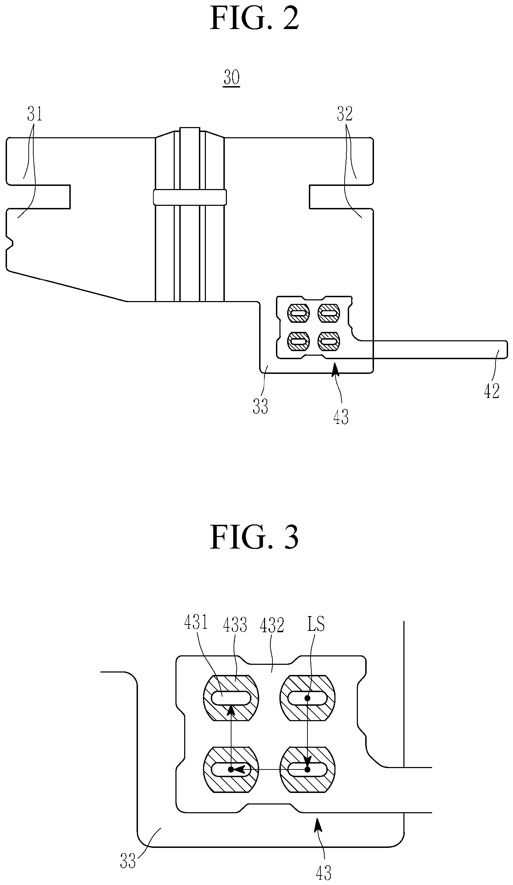

FIG. 1 illustrates a partial top plan view of a rechargeable battery module according to an embodiment of the present disclosure, FIG. 2 illustrates a top plan view in which a connection portion of a flexible printed circuit is connected to a bus bar applied to FIG. 1, and FIG. 3 illustrates an enlarged top plan view of the connection portion of the flexible printed circuit for the bus bar in FIG. 2.

Referring to FIG. 1 to FIG. 3, the rechargeable battery module according to the embodiment includes a bus bar holder 20, a bus bar 30, and a flexible printed circuit (FPC) 40 covering a plurality of battery cells 10. In one or more embodiments, the battery cells 10 are rechargeable batteries.

The bus bar holder 20 includes an electrical insulating material and is configured to cover the plurality of battery cells 10 and to hold (fix) the position of the bus bars 30 that electrically connect the battery cells 10. The bus bars 30 are on the bus bar holder 20 and electrically connect the battery cells 10 under the bus bar holder 20.

The flexible printing circuit (FPC) 40 is configured to detect the temperature of the bus bars 30 and the voltage of the battery cell 10 and to transmit the temperature and the voltage to a battery management system (BMS). In one or more embodiments, the flexible printed circuit 40 mounts a temperature sensor, and the temperature sensor is covered with an insulating material to be electrically insulated, and physically (directly or indirectly) contacts one or more of the battery cells 10 to detect the temperature of the battery cell 10.

The flexible printed circuit (FPC) 40 is on the bus bar holder 20 and connected to the bus bar 30. The FPC 40 is formed by coating both surfaces of a circuit pattern with a film and the FPC 40 is configured to transmit a signal sensing the voltage of the battery cell 10 through the bus bar 30. In one or more embodiments, the flexible printed circuit (FPC) 40 is directly connected to the bus bar 30.

In one or more embodiments, the bus bar 30 further includes cell connection portions 31 and 32 connected to neighboring battery cells 10, and an extension portion 33 protruding from one of the cell connection portions 31 and 32 to one side, as shown in FIG. 2.

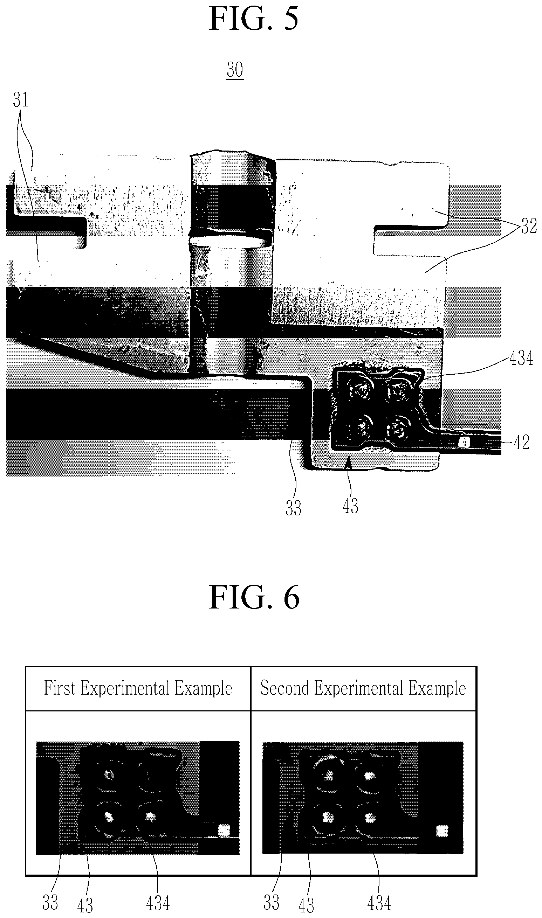

The flexible printed circuit 40 includes a branch portion 42 (see FIG. 5) extending from a main body portion 41 connected to the battery management system and having a width narrower than that of the main body portion 41, and an expansion portion 43 having an expanded area in the branch portion 42. The expansion portion 43 is connected to the extension portion 33 of the bus bar 30 by soldering bonding, for example.

Despite the branch portion 42 having a narrow width and narrow area, the expansion portion 43 is expanded and has a wider width and a larger area than the branch portion 42. Therefore, the expansion portion 43 and the extension portion 33 may be firmly coupled (e.g., soldering-bonded together).

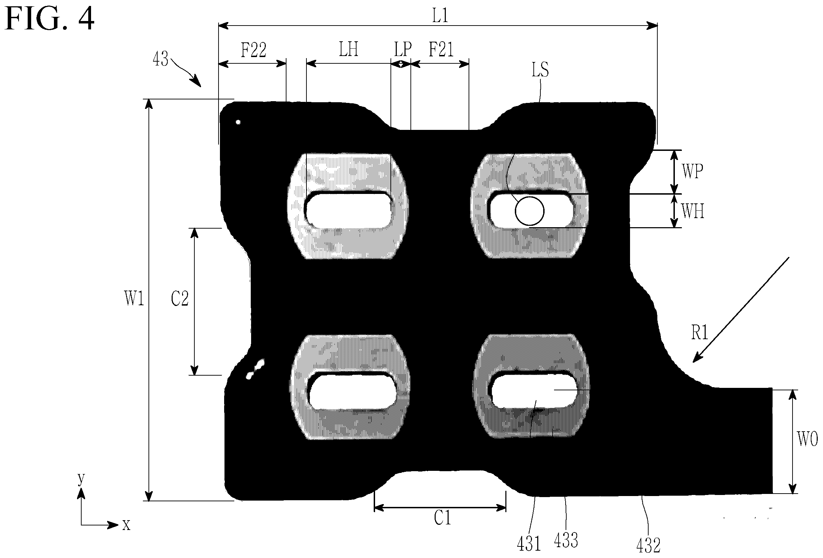

FIG. 4 illustrates a planar image of the connection portion of the flexible printed circuit of the embodiment illustrated in FIG. 1 to FIG. 3, and FIG. 5 illustrates an image in which a connection portion of a flexible printed circuit is bonded to a bus bar according to the embodiment illustrated in FIG. 1.

Referring to FIG. 2 to FIG. 5, the expansion portion 43 includes a plurality of through holes 431 penetrating a foil connected to a circuit pattern, a soldering pattern 433 formed by removing the coating of a film 432 from the outside of the through holes 431, and a soldering portion 434 bonding the extension portion 33 exposed through the through holes 431 and the soldering pattern 433.

As a non-limiting example, the foil comprises copper or aluminum. The through holes 431 extend through the foil, and allow solder melted by a laser to be bonded to the extension portion 33 through the through holes 431 during soldering. During a manufacturing process, wire solder is supplied onto each of the through holes 431 and is melted by a laser LS irradiated to the through hole 431.

The soldering pattern 433 includes a copper or aluminum foil. Some of the solder melted by the laser LS reaches the extension portion 33 through the through hole 431 and is bonded to the extension portion 33, and the remaining portion thereof is bonded to the soldering pattern 433. That is, the soldering portion 434 connects the extension portion 33 of the bus bar 30 and the soldering pattern 433 of the flexible printed circuit 40 to each other.

Accordingly, the extension portion 33 of the bus bar 30 electrically connected to the battery cell 10 detects and transmits the voltage of the battery cell 10 to the flexible printed circuit 40 through the soldering pattern 433 of the expansion portion 43.

In one or more embodiments, the film 432 may include polyethylene terephthalate (PET) or polyethylene naphthalate (PEN) with a low heat-resistant temperature to reduce material costs.

In the embodiment illustrated in FIG. 4, a plurality of through holes 431 are arranged in the width direction (y-axis direction) and the length direction (x-axis direction) of the expansion portion 43 (e.g., the through holes 431 are arranged in rows and columns). In one or more embodiments, four through holes 431 are arranged in a grid having two rows in the width direction and two columns in the length direction.

As shown in FIG. 3, when wire solder is supplied from left to right, the soldering and bonding by irradiating the laser LS is sequentially performed from the upper right through hole 431 to the lower right through hole 431, from the lower right through hole 431 to the lower left through hole 431, and from the lower left through hole 431 to the upper left through hole 431. This laser (LS) irradiation process does not interfere with the laser (LS) irradiation due to the wire solder.

Referring back to FIG. 4, the expansion portion 43 has an area (L1*W1) defined by a first length L1 in the length direction (x-axis direction) of the branch portion 42 and a first width W1 in the width direction (y-axis direction) crossing the length direction. The area (L1*W1) of the expansion portion 43 is configured to enable sufficient peel strength and resistance when soldering the expansion portion 43 to the extension portion 33 of the bus bar 30. In one or more embodiments, when the width W0 of the branch portion 42 is approximately 3 mm, the first length L1 of the expansion portion 43 may be approximately 12 mm and the first width W1 thereof may be approximately 11 mm.

Each of the through holes 431 has a slot hole structure having a hole width WH in the width direction (y-axis direction) and a hole length LH in the length direction (x-axis direction). By forming the hole length LH longer than the hole width WH, it is possible to secure sufficient peel strength in the length direction in the soldering bonding state. In one or more embodiments, in each of the through holes 431, the hole length LH may be approximately 2.4 mm and the hole width WH may be approximately 1 mm.

The soldering pattern 433 includes a pattern width WP having substantially the same size as the hole width WH on both sides of the through hole 431 in the width direction (y-axis direction), and a pattern length LP connected to the pattern width WP on both end of the through hole 431 in the length direction (x-axis direction) that has a larger curvature (e.g., a larger radius) than curved ends of the through hole 431. Because the pattern width WP is formed to have a larger area than the pattern length LP, when the wire solder is melted and bonded by irradiating the laser LS to the center of the through hole 431, damage to the film 432 is prevented (or at least mitigated) while sufficiently securing the area of the soldering portion 434. In one or more embodiments, the pattern width WP may be approximately 1.5 mm, and the pattern length LP may be approximately 0.5 mm.

In addition, the expansion portion 43 includes an eleventh inner-coating portion F11 and a twelfth outer coating portion F12 in the width direction (y-axis direction). The eleventh inner-coating portion F11 is between the soldering patterns 433 in the width direction (y-axis direction) and is an area of the foil coated with the film 432. The twelfth outer coating portion F12 is an area outside of the soldering pattern 433 in the width direction (y-axis direction) and is an area of the foal coated with the film 432. The eleventh inner-coating portion F11 has a size substantially equal to twice that of the twelfth outer coating portion F12. The soldering pattern 433 and the soldering portion 434 provide peel strength, the eleventh inner-coating portion F11 and the twelfth outer coating portion F12 provide the durability of the expansion portion 43 in respective areas, thereby preventing a reduction in peel strength. Accordingly, the peel strength of the expansion portion 43 to the extension portion 33 is set by the soldering pattern 433 and the soldering portion 434. In one or more embodiments, the eleventh inner-coating portion F11 may be approximately 2 mm, and the twelfth outer coating portion F12 may be approximately 1 mm.

In addition, the expansion portion 43 includes a first concave portions C1 in each of the twelfth outer coating portions F12. The first concave portion C1 is configured to absorb the tensile force applied in the length direction (x-axis direction) in the soldering bonding state and is configured to induce deformation, thereby further securing the peel strength for the entire expansion portion 43.

In addition, the expansion portion 43 includes a 21st inner-coating portion F21 and a 22nd outer coating portion F22 each in the length direction (x-axis direction). The 21st inner-coating portion F21 is between the soldering patterns 433 in the length direction (x-axis direction) and is an area of the film coated with the film 432. The 22nd outer coating portion F22 is an area on the outside of the soldering pattern 433 in the length direction (x-axis direction) and is an area of the foil coated with the film 432. The 21st inner-coating portion F21 has a size similar (e.g., substantially equal) to that of the 22nd outer coating portion F22. The soldering pattern 433 and the soldering portion 434 provide peel strength, the 21st inner-coating portion F21 and the 22nd outer coating portion F22 provide the durability of the expansion portion 43 in respective areas, thereby preventing a reduction in peel strength. Accordingly, the peel strength of the expansion portion 43 to the extension portion 33 is set by the soldering pattern 433 and the soldering portion 434. In one or more embodiments, the 21st inner-coating portion F11 may be approximately 1.6 mm, and the 22nd outer coating portion F22 may be approximately 1.8 mm. In this context the term approximately means a deviation of +/- 0.15 mm.

In addition, the expansion portion 43 includes a second concave portion C2 in each of the 22nd outer coating portions F22. The second concave portion C2 is configured to absorb the tensile force that crosses the tensile force applied in the length direction (x-axis direction) in the soldering bonding state and is configured to induce deformation, thereby further securing the peel strength for the entire expansion portion 43.

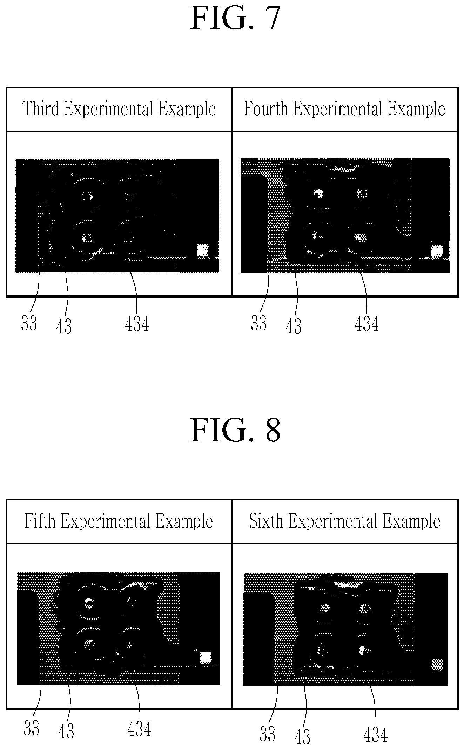

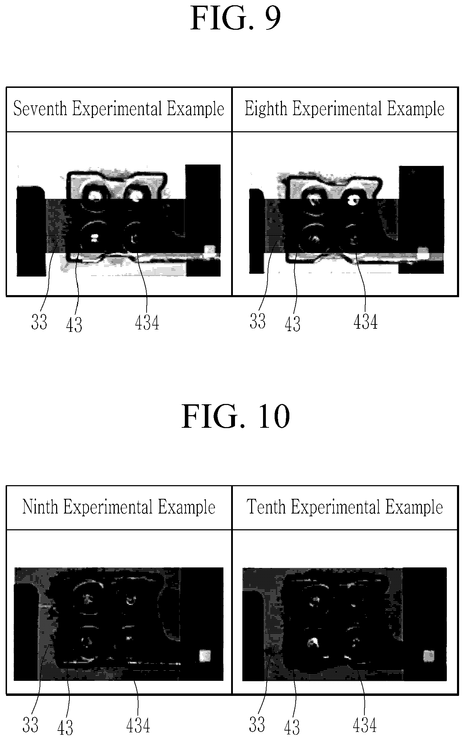

Hereinafter, various experimental examples will be described. FIG. 6 illustrates images of a first experimental example and a second experimental example in which a connection portion of a flexible printed circuit is connected to a bus bar according to an embodiment of the present disclosure, FIG. 7 illustrates images of a third experimental example and a fourth experimental example in which a connection portion of a flexible printed circuit is connected to a bus bar according to an embodiment of the present disclosure, FIG. 8 illustrates images of a fifth experimental example and a sixth experimental example in which a connection portion of a flexible printed circuit is connected to a bus bar according to an embodiment of the present disclosure, FIG. 9 illustrates images of a seventh experimental example and an eighth experimental example in which a connection portion of a flexible printed circuit is connected to a bus bar according to an embodiment of the present disclosure, and FIG. 10 illustrates images of a ninth experimental example and a tenth experimental example in which a connection portion of a flexible printed circuit is connected to a bus bar according to an embodiment of the present disclosure.

Referring to FIG. 6 to FIG. 10, during a manufacturing process, the power of a laser irradiated at a wire solder is approximately 70 W, a preheating temperature of the extension portion 33 of the bus bar 30 is approximately 240 °C, and the entire process time takes approximately 25 seconds. After first preheating, wire solder supply, second preheating, wire solder supply, third preheating, wire solder supply, and fourth preheating, the expansion portion 43 is soldered and bonded to the extension portion 33 through a laser soldering process. As a result, the first to tenth experimental examples as shown in FIGS. 6 to 10 were obtained.

The resistance values of the expansion portion 43 and the extension portion 33 bonded to each other by laser soldering were in a range from approximately 2.5 mΩ to approximately 3.5 mΩ in the first to tenth experimental examples, as shown in Table 1 below.

**Table 1**

| Experimental Example | Resistance Value (mΩ) | Experimental Example | Resistance Value (mΩ) |
|---|---|---|---|
| First Experimental Example | 2.7 | Sixth Experimental Example | 3.5 |
| Second Experimental Example | 3.1 | Seventh Experimental Example | 3.4 |
| Third Experimental Example | 3.1 | Eighth Experimental Example | 3.4 |
| Fourth Experimental Example | 3.0 | Ninth Experimental Example | 3.3 |
| Fifth Experimental Example | 2.5 | Tenth Experimental Example | 3.0 |

The results in Table 1 show that the resistance value is in a range from approximately 2.5 mΩ to approximately 3.5 mΩ even though the expansion portion 43 of the flexible printed circuit 40 and the extension portion 33 of the bus bar 30 are directly bonded together, which is lower than the required minimum resistance value of approximately 5 mΩ, and therefore the voltage of the battery cell 10 may be detected even though the nickel tab (Ni-tab) connecting the FPC to the bus bar is omitted.

As shown in Table 2, the peel strength (without bonding) between the expansion portion 43 and the extension portion 33 bonded by the laser soldering was in a range from approximately 8.41 N to approximately 11.71 N (average of approximately 9.71 N) in the first to fifth experimental examples.

**Table 2**

| Experimental Example | Peel Strength (N) |
|---|---|
| First Experimental Example | 10.85 |
| Second Experimental Example | 8.66 |
| Third Experimental Example | 8.92 |
| Fourth Experimental Example | 11.72 |
| Fifth Experimental Example | 8.41 |

The results in Table 2 show that the peel strength is in a range from approximately 8.41 N to approximately 11.71 N even though the expansion portion 43 of the flexible printed circuit 40 and the extension portion 33 of the bus bar 30 are directly bonded together, which is higher than the required minimum peel strength of 5 N, and therefore the peel strength may be maintained even though the nickel tab (Ni-tab) connecting the FPC to the bus bar is omitted.

While this invention has been described in connection with what is presently considered to be practical exemplary embodiments, it is to be understood that the invention is not limited to the disclosed embodiments, but, on the contrary, is intended to cover various modifications and equivalent arrangements included within the scope of the appended claims.

**Description of symbols**

| | | | |
|---|---|---|---|
| 10: | battery cell | 20: | bus bar holder |
| 30: | bus bar | 31, 32: | cell connection portion |
| 33: | extension portion | 40: | flexible printed circuit (FPC) |
| 41: | main body portion | 42: | branch portion |
| 43: | expansion portion | 431: | through hole |
| 432: | film | 433: | soldering pattern |
| 434: | soldering portion | C1: | first concave portion |
| C2: | second concave portion | F11: | eleventh inner-coating portion |
| F12: | twelfth outer coating portion | | |
| F21: | 21st inner-coating portion | | |
| F22: | 22nd outer coating portion | | |
| L1: | first length | | |
| LH: | hole length | LP: | pattern length |
| LS: | laser | W0: | width |
| W1: | first width | WH: | hole width |
| WP: | pattern width | | |

## Claims

1. A rechargeable battery module comprising:
a bus bar holder (20) covering a plurality of battery cells (10);
a bus bar (30) on the bus bar holder (20), the bus bar (30) electrically connecting the plurality of battery cells (10); and
a flexible printed circuit on the bus bar holder (20), the flexible printed circuit comprising a film (432) coating both surfaces of a circuit pattern, the flexible printed circuit being configured to transmit a signal that detects a voltage of a battery cell (10) of the plurality of battery cells (10) connected to the bus bar (30),
wherein the bus bar (30) comprises an extension portion (33) protruding in one direction, and
wherein the flexible printed circuit comprises a main body portion (41), a branch portion (42) extending from the main body portion (41), and an expansion portion (43) soldered to the extension portion (33), the expansion portion (43) having a larger area than the branch portion (42).

2. The rechargeable battery module of claim 1, wherein the expansion portion (43) comprises:
at least one through hole penetrating a foil connected to the circuit pattern,
at least one soldering pattern (433) exposed by an opening in a film (432) around the at least one through hole, and
a soldering portion (434) bonding the extension portion (33) exposed through the at least one through hole to the at least one soldering pattern (433).

3. The rechargeable battery module of claim 2, wherein the foil comprises copper or aluminum.

4. The rechargeable battery module of claim 2, wherein the expansion portion (43) has an area comprising a first length (L1) in a length direction of the branch portion (42) and a first width (W1) in a width direction crossing the length direction.

5. The rechargeable battery module of claim 4, wherein the branch portion (42) is at an outermost side of the expansion portion (43) in the width direction, wherein the branch portion (42) has a width (W0) that is smaller than the first width (W1) of the expansion portion (43), and wherein the branch portion (42) extends in the length direction.

6. The rechargeable battery module of claim 5, further comprising a rounded corner where the branch portion (42) and the expansion portion (43) are connected.

7. The rechargeable battery module of claims 2 to 5, wherein the at least one through hole comprises a plurality of through holes arranged in a width direction and a length direction.

8. The rechargeable battery module of claims 4 to 7, wherein the at least one through hole comprises a plurality of through holes, wherein two through holes of the plurality of through holes are arranged in the width direction, and wherein another two through holes of the plurality of through holes are arranged in the length direction.

9. The rechargeable battery module of claim 8, wherein each of the plurality of through holes has a slot hole structure having a hole width (WH) in the width direction and a hole length (LH) in the length direction.

10. The rechargeable battery module of claim 9, wherein the at least one soldering pattern (433) comprises a plurality of soldering patterns (433), and wherein each of the plurality of soldering patterns (433) comprises:
a pattern width (WP) on both sides of each of the plurality of through holes in the width direction and having substantially a same size as the hole width (WH), and
a pattern length (LP) connected to both sides of the pattern width (WP) in the length direction, the pattern length (LP) having a larger curvature than the slot hole structure of each of the plurality of through holes.

11. The rechargeable battery module of claims 8 to 10, wherein the expansion portion (43) comprises:
an eleventh inner-coating portion (F11) between two soldering patterns (433) of the plurality of soldering patterns (433) in the width direction, the eleventh inner-coating portion (F11) comprising a portion of the foil coated with the film (432), and
a twelfth outer coating portion (F12) outside the two soldering patterns (433) in the width direction, the twelfth outer coating portion (F12) comprising another portion of the foil coated with the film (432), and
wherein the eleventh inner-coating portion (F11) has a size substantially equal to approximately twice that of the twelfth outer coating portion (F12).

12. The rechargeable battery module of claim 11, wherein the expansion portion (43) includes a first concave portion (C1) in the twelfth outer coating portion (F12).

13. The rechargeable battery module of claims 8 to 12, wherein the expansion portion (43) comprises:
a 21st inner-coating portion (F21) between two soldering patterns (433) of the plurality of soldering patterns (433) in the length direction, the 21st inner-coating portion (F21) comprising a portion of the foil coated with the film (432), and
a 22nd outer coating portion (F22) outside the two soldering patterns (433) in the length direction, the 22nd outer coating portion (F22) comprising another portion of the foil coated with the film (432), and
the 21st inner-coating portion (F21) has a size smaller than that of the 22nd outer coating portion (F22) and/or wherein the expansion portion (43) includes a second concave portion (C2) in the 22nd outer coating portion (F22).

14. The rechargeable battery module of claim 13, wherein the 21st inner-coating portion (F11) may be approximately 1.6 mm, and the 22nd outer coating portion (F22) may be approximately 1.8 mm.

15. The rechargeable battery module of claims 2 to 14, wherein the soldering portion (434) bonds the at least one soldering pattern (433) and the extension portion (33) exposed through the at least one through hole.
